# EUROPEAN PATENT APPLICATION

(11) **EP 3 623 155 A1**
(43) Date of publication of application: **18.03.2020**
(21) Application number: 19150788.8
(22) Date of filing: 08.01.2019
(51) Int. Cl.: B33Y 10/00, B33Y 50/02, B29C 64/124, B29C 64/129, B29C 64/241

(54) **METHOD OF PEELING PHYSICAL MODEL FROM MATERIAL TANK**

(30) Priority: 11.09.2018 CN 201811057315
(71) Applicant: XYZprinting, Inc., New Taipei City 22201 (TW); Kinpo Electronics, Inc., New Taipei City 22201 (TW)
(72) Inventor: CHENG, Po-Wei, 22201 New Taipei City (TW)
(74) Representative: 2K Patentanwälte Blasberg Kewitz & Reichel

(57) **Abstract**

A method of peeling physical model from material tank applied to a stereolithography 3D printer (2) is provided. The method is to retrieve a printing area value of the printed slice physical model (42, 43) after completion of printing one layer of the slice physical model (42, 43) each time, lift a curing platform (24) of the stereolithography 3D printer (2), and move a material tank (23) of the stereolithography 3D printer (2) during lifting for peeling the layer of printed slice physical model (42, 43) when the printing area value is not less than a threshold.

## Description

### BACKGROUND OF THE INVENTION

### Field of the Invention

The technical field relates to 3D printing and more particularly related to a method of peeling physical model from material tank.

### Description of Related Art

A stereolithography 3D printer of the related art has an ability to cure the light-curable materials into a 3D physical model by light-irradiating. More specifically, the stereolithography 3D printer comprises a curing platform, a material tank, and a light module. The material tank is used to accommodate the fluid light-curable materials, and a demodeling film is laid on the bottom of the material tank. A surface of above-mentioned demodeling film is very smooth, so as to reduce the stuck extent of the cured light-curable materials (namely slice physical model) being stuck on the tenacity film and prevent the printing from failure.

Because the cured light-curable materials have stickiness and may adhere to the demodeling film, the stereolithography 3D printer must provide a stronger lift force by the curing platform for peeling the slice physical model from the bottom of the material tank.

Moreover, when an area of the slice physical model is bigger, the adhesion is stronger, such that the stereolithography 3D printer must provide the stronger lifting force by the curing platform for peeling the slice physical model form the bottom of the material tank.

However, above stronger lifting force may make the demodeling film be peeled from the bottom of the material tank or the slice physical model be damaged.

Thus, the stereolithography 3D printing technology of the related art has above-mentioned problems, there is a need for a more effective solution.

### SUMMARY OF THE INVENTION

The present disclosed example is directed to a method of peeling physical model from material tank having an ability to provide a horizontal force to effectively peeling the slice physical model from the material tank when an area value of the slice physical model is too big.

One of the exemplary embodiments, a method of peeling physical model from material tank applied to a stereolithography 3D printer, the stereolithography 3D printer comprises a light module, a curing platform, a material tank and a moving module, a light-transmissive demodeling film being laid on a bottom of the material tank, the method of peeling physical model from material tank comprises following steps: selecting one of multiple layers of print data in order; making a modeling plane of the curing platform be a default thickness from the demodeling film; controlling the light module to irradiate heading to the modeling plane according to the selected layer of print data for printing one layer of slice physical model on the modeling plane; retrieve a printing area value of the printed layer of slice physical model; lifting the curing platform up when the printing area value is not less than a first threshold, and controlling the moving module to move the material tank during lifting the curing platform for peeling the layer of slice physical model from the material tank; and, performing above steps repeatedly until all of the multiple layers of slice physical models have been printed and stack as a 3D physical model.

The present disclosed example can drastically reduce a probability of the demodeling film or physical model being damaged during peeling.

### BRIEF DESCRIPTION OF DRAWING

The features of the present disclosed example believed to be novel are set forth with particularity in the appended claims. The present disclosed example itself, however, may be best understood by reference to the following detailed description of the present disclosed example, which describes an exemplary embodiment of the present disclosed example, taken in conjunction with the accompanying drawings, in which:
Fig. 1A is a first schematic view of stereolithography 3D printing of the related art;
Fig. 1B is a second schematic view of stereolithography 3D printing of the related art;
Fig. 1C is a third schematic view of stereolithography 3D printing of the related art;
FIG. 2 is an architecture diagram of a stereolithography 3D printer according to one embodiment of the present disclosed example;
Fig. 3A is a look-down schematic view of moving material tank according to one embodiment of the present disclosed example;
Fig. 3B is a look-down schematic view of moving material tank according to another embodiment of the present disclosed example;
Fig. 4 is a schematic view of appearance of a stereolithography 3D printer according to one embodiment of the present disclosed example;
Fig. 5A is a first schematic view of stereolithography 3D printing according to one embodiment of the present disclosed example;
Fig. 5B is a second schematic view of stereolithography 3D printing according to one embodiment of the present disclosed example;
Fig. 5C is a third schematic view of stereolithography 3D printing according to one embodiment of the present disclosed example;
Fig. 5D is a fourth schematic view of stereolithography 3D printing according to one embodiment of the present disclosed example;
Fig. 5E is a fifth schematic view of stereolithography 3D printing according to one embodiment of the present disclosed example;
Fig. 5F is a sixth schematic view of stereolithography 3D printing according to one embodiment of the present disclosed example;
Fig. 6 is a flowchart of a method of peeling physical model from material tank according to a first embodiment of the present disclosed example; and
Fig. 7 is a flowchart of a method of peeling physical model from material tank according to a second embodiment of the present disclosed example.

### DETAILED DESCRIPTION OF THE INVENTION

In cooperation with attached drawings, the technical contents and detailed description of the present disclosed example are described thereinafter according to some exemplary embodiments, being not used to limit its executing scope. Any equivalent variation and modification made according to appended claims is all covered by the claims claimed by the present disclosed example.

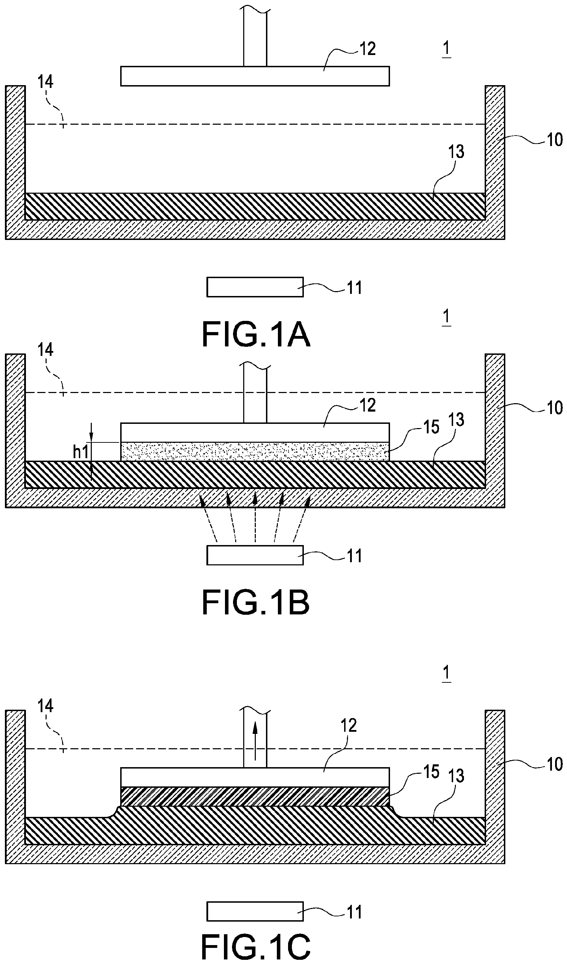

Please refer to Fig. 1A to Fig. 1C simultaneously, Fig. 1A is a first schematic view of stereolithography 3D printing of the related art, Fig. 1B is a second schematic view of stereolithography 3D printing of the related art, and Fig. 1C is a third schematic view of stereolithography 3D printing of the related art. Fig. 1A to Fig. 1C are used to exemplary explain the technical problems solved by the present disclosed example.

As shown in Fig. 1A, in general, the stereolithography 3D printer 1 of the related art (take an uplight stereolithography 3D printer for example) comprises a material tank 10, a light module 11 and a curing platform 12. The material tank 10 is used to accommodate the fluid light-curable materials 14, and a light-transmissive demodeling film 13 is laid on the bottom of the material tank 10.

As shown in Fig. 1B, the stereolithography 3D printer 1 may control the curing platform 12 to lower for contacting with the light-curable materials 14, and make a worktop of the curing platform 12 be a default thickness h1 away from the demodeling film 13. Then, the stereolithography 3D printer 1 controls the light module 11 to irradiate heading to the light-curable materials 14 between the curing platform 12 and the demodeling film 13 for making the light-curable materials 14 solidify into the first layer of slice physical model 15.

Then, as shown in Fig. 1C, the stereolithography 3D printer 1 controls the curing platform 12 to rise to make the first layer of printed slice physical model leave from the light-curable materials 14 for completion of printing one layer of slice physical model 15.

However, during rising, the stickiness of the slice physical model 15 may damage the demodeling film 13, such that the demodeling film 13 be peeled or has a deformation (as shown in Fig. 1C). Or, the slice physical model 15 may be damaged, such as the slice physical model 15 fracturing. Moreover, when an area of the slice physical model 15 is bigger, the adhesion generated by above stickiness is stronger, such that it is possible that the demodeling film 13 and the slice physical model 15 being damaged.

Thus, the stereolithography 3D printing technology of the related art may damage the demodeling film 13 and cause printing failure when printing the slice physical model 15 having the bigger area.

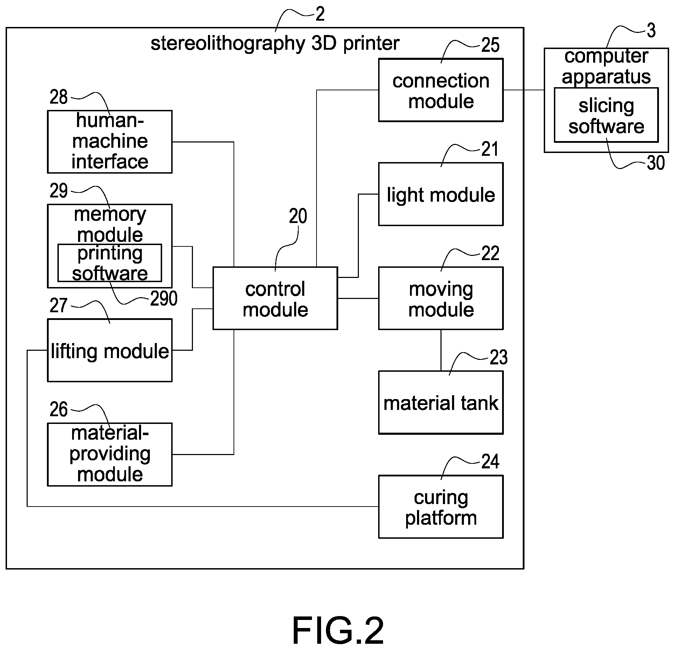

Please refer to FIG. 2, which is an architecture diagram of a stereolithography 3D printer according to one embodiment of the present disclosed example. The stereolithography 3D printer 2 mainly comprises a light module 21, a moving module 22, a material tank 23, a curing platform 24 and a control module 20 electrically connected to above devices.

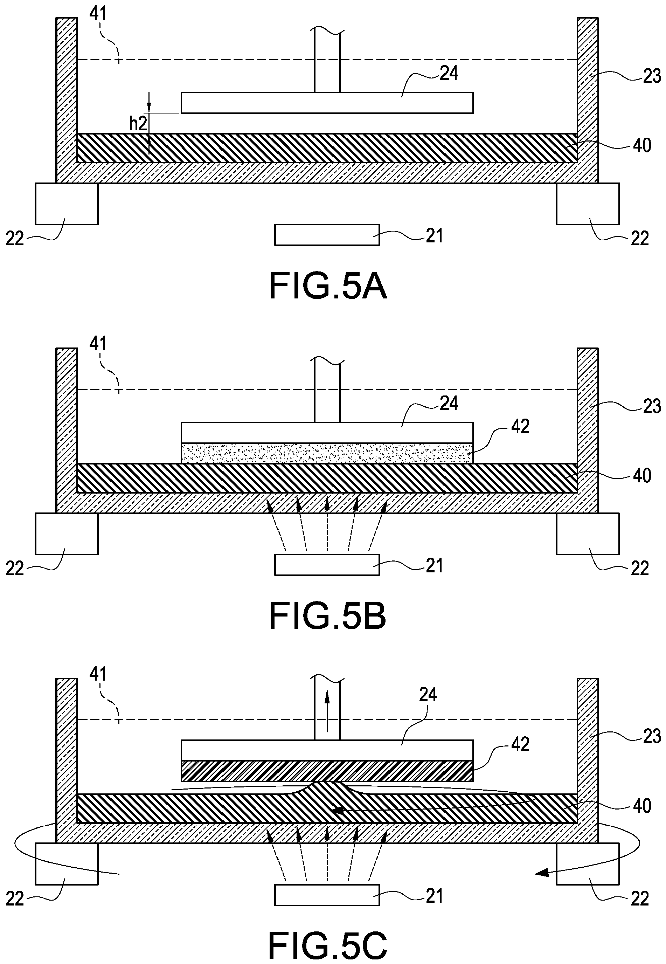

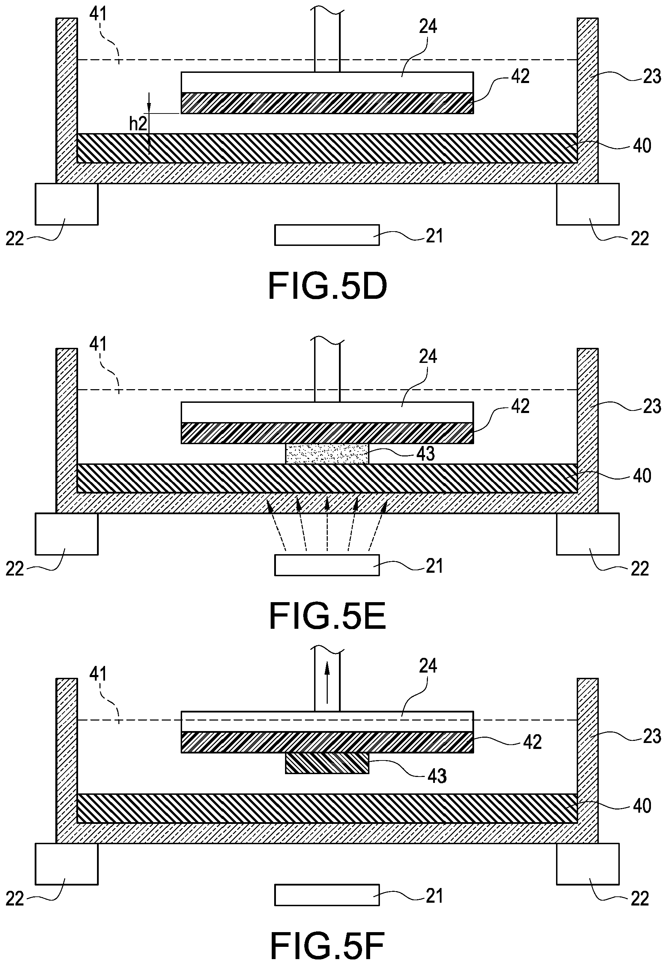

The control module 20 is configured to control the stereolithography 3D printer 2 to execute the stereolithography 3D printing. The light module 21 is configured to emit the beams heading to the curing platform 24 (the light module 21 may be a single point light source, a line light source or a plane light source). The beams irradiate one or more designated print position(s) between the material tank 23 and the curing platform 24 for curing the light-curable materials in the light path (the printing positions shown in Fig. 5B are located at the light-curable materials 41 between the curing platform 24 and the demodeling film 40, and the printing positions shown in Fig. 5E are located at the light-curable materials 41 between the first layer of slice physical model 42 and the demodeling film 40).

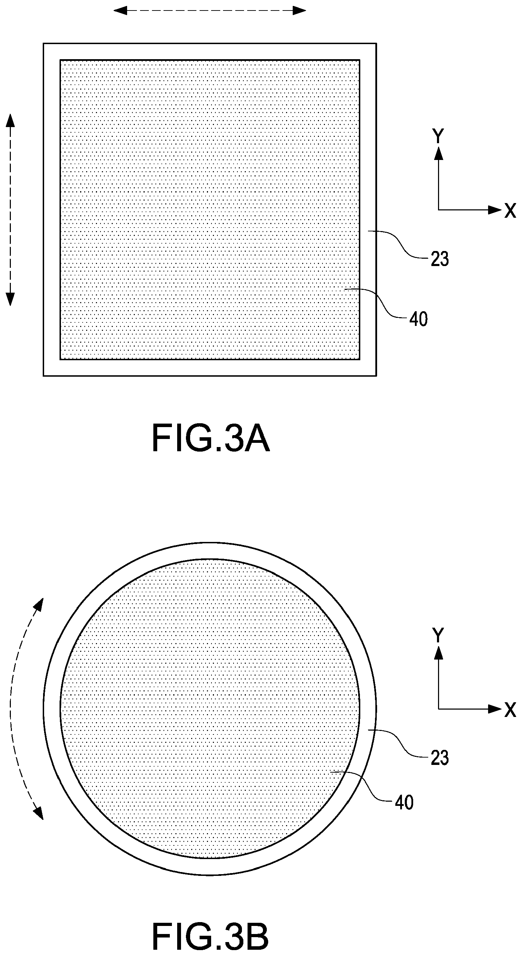

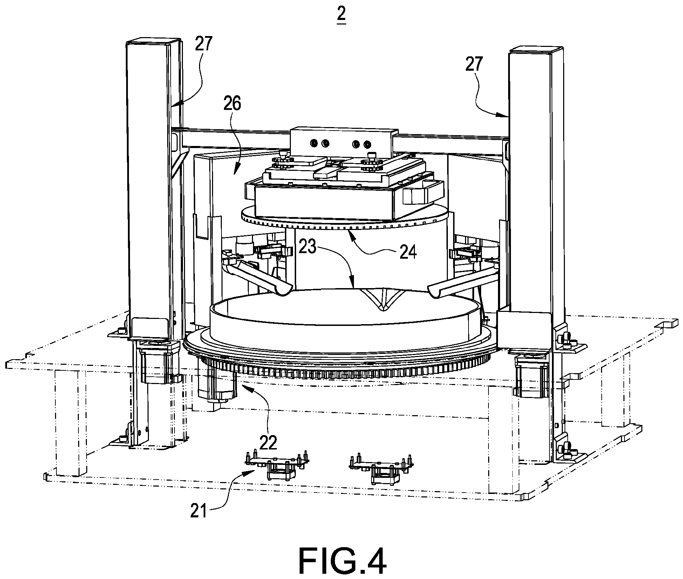

The material tank 23 is used to accommodate the fluid light-curable materials 41, such as UV curable resin. One of the exemplary embodiments, when the stereolithography 3D printer 2 is an uplight stereolithography 3D printer (as shown in Fig. 4), a bottom case of the material tank 23 may be made from the light-transmissive material, and one layer of light-transmissive demodeling film (such as the demodeling film 40 shown in Fig.3A and Fig. 3B, the demodeling film 40 may be made from light-transmissive silicone or Teflon) is laid on the bottom inside the tank. Thus, the beams irradiated by the light module 21 may transmit through the bottom case of the material tank 23 and the demodeling film 40 to irradiate the light-curable materials 41 in the material tank 23.

The moving module 22 is connected to the material tank 23, and is configured to be controlled to move (such as horizontal movement, rotation or a combination of horizontal movement and rotation) the material tank 23 by the control module 20 for making the light-curable materials 41 accommodated in the material tank 23 flow caused by moving the material tank 23. The curing platform 24 is used to carry the manufactured 3D physical model.

Please refer to Fig. 3A, which is a look-down schematic view of moving material tank according to one embodiment of the present disclosed example. As shown in the figure, in this example, a shape of the material tank 23 is square (the shape of the material tank 23 can be changed to other shapes), and a demodeling film 40 is laid on a bottom of the material tank 23. Moreover, the moving module 22 horizontally moves the material tank 23 back and forth in the horizontal direction (such as any direction in the X-Y plane). For example, moving the material tank 23 back and forth along the X-axis for 15 centimeters.

Please refer to Fig. 3B, which is a look-down schematic view of moving material tank according to another embodiment of the present disclosed example. As shown in the figure, in this example, the shape of the material tank 23 is circular (the shape of the material tank 23 can be changed to other shapes), and the demodeling film 40 is laid on the bottom of the material tank 23. Moreover, the moving module 22 horizontally rotates the material tank 23 (such as horizontally rotating along any direction in the X-Y plane). For example, rotating 180 degrees clockwise, rotating 180 degrees anti-clockwise or a combination of rotating clockwise and anti-clockwise.

Please be noted that although the material tank 23 which its shape is non-circular (such as being square, rectangle or regular hexagon) has the advantages of easy to make, big printable area and so forth, the non-circular material tank 23 is not suitable for the moving means of rotation because rotating the non-circular material tank 23 needs larger space. Thus, the present disclosed example can drastically save the space required by rotation via using the moving means of horizontally moving back and forth on the non-circular material tank 23.

Moreover, for the circular material tank 23, the present disclosed example can achieve the following advantages via using the moving means of horizontally rotating: it being not necessary to additionally plan a moving space for the material tank 23 (by situ rotation); and it being easy to adjust a flow speed of the light-curable materials 41 (by adjusting the rotating speed of the material tank 23). Moreover, the circular material tank 23 can finely adjust the provided horizontal force because of an ability of finely adjusting the flow speed of the light-curable materials 41. Above horizontal force is used to peel the slice physical model from the bottom of the material tank 23.

Please refer to Fig. 2, one of the exemplary embodiments, the stereolithography 3D printer 2 further comprises a connection module 25 electrically connected to the control module 20, such as USB module, PCI bus module, Wi-Fi module or Bluetooth module. The connection module 25 is configured to connect to the computer apparatus 3 and receive the print data from the computer apparatus 3. One of the exemplary embodiments, the computer apparatus 3 stores a slicing software 30, the computer apparatus 3 may execute the slicing software 30 to execute a slicing process on the 3D model data for obtaining the multiple layers of print data (such as a plurality of 2D images), and transfer the print data to the connection module 25 for 3D printing.

One of the exemplary embodiments, the stereolithography 3D printer 2 further comprises a material-providing module 26 electrically connected to the control module 20. The material-providing module 26 accommodates the fluid light-curable materials 41 and has an ability of pouring the designated volume of light-curable materials 41 (with designated flow rate) into the material tank 23.

One of the exemplary embodiments, the stereolithography 3D printer 3 further comprises a lifting module 27 electrically connected to the control module 20 and connected to the curing platform 24. The lifting module 27 may be controlled by the control module 20 to move the curing platform 24 along a default axis (such as lifting in the Z-axis).

One of the exemplary embodiments, the stereolithography 3D printer 2 further comprises a human-machine interface 28 (such as buttons, a monitor, indicators, a buzzer, or any combination of above elements) electrically connected to the control module 20. The human-machine interface 28 is configured to receive a user operation and output the print-related information.

One of the exemplary embodiments, the stereolithography 3D printer 2 further comprises a memory module 29 electrically connected to the control module 20. The memory module 29 is used to store data, such as print data.

One of the exemplary embodiments, the memory module 29 comprises a non-transient computer-readable recording media, above non-transient computer-readable recording media stores a printing software 290 (such as a firmware or an operating system of the stereolithography 3D printer 2), and a plurality of computer-executable codes are recorded in the printing software 290. The control module 20 may perform each step of the method of peeling physical model from material tank of each embodiment of the present disclosed example after execution of the printing software 290.

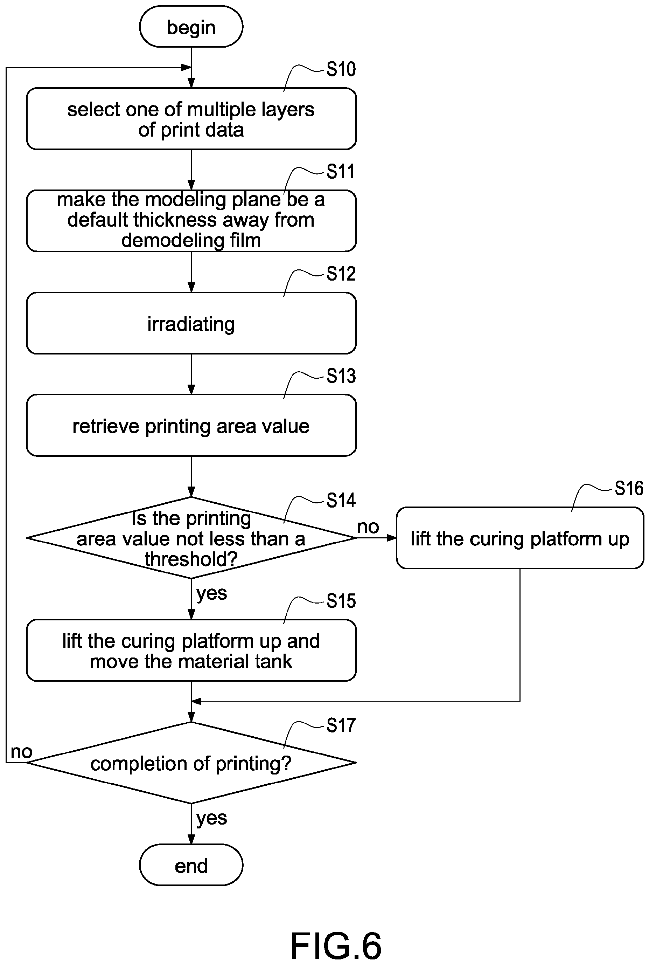

Please refer to Fig. 4 to Fig. 6 simultaneously, Fig. 4 is a schematic view of appearance of a 3D printer according to one embodiment of the present disclosed example, Fig.5A is a first schematic view of stereolithography 3D printing according to one embodiment of the present disclosed example, Fig.5B is a second schematic view of stereolithography 3D printing according to one embodiment of the present disclosed example, Fig.5C is a third schematic view of stereolithography 3D printing according to one embodiment of the present disclosed example, Fig.5D is a fourth schematic view of stereolithography 3D printing according to one embodiment of the present disclosed example, Fig.5E is a fifth schematic view of stereolithography 3D printing according to one embodiment of the present disclosed example, Fig.5F is a sixth schematic view of stereolithography 3D printing according to one embodiment of the present disclosed example, and Fig. 6 is a flowchart of a method of peeling physical model from material tank according to a first embodiment of the present disclosed example.

The stereolithography 3D printer 2 shown in Fig. 4 and Fig. 5A to Fig. 5F is configured to move the material tank 23 by rotation.

The method of the method of peeling physical model from material tank of each embodiment of the present disclosed example may be implemented by the stereolithography 3D printer 2 shown in Fig. 2 to Fig. 5. The following description takes the moving means being moving horizontally as shown in Fig. 4 to Fig. 5F for explaining. The method of peeling physical model from material tank of this embodiment comprises following steps.

Step S10: the control module 20 of the stereolithography 3D printer 2 selects one of the multiple layers of print data in order, such as the first layer of print data.

One of the exemplary embodiments, the multiple layers of print data may comprise a plurality of 2D images, each of the 2D images corresponds to a layer value and is used to describe a shape of the corresponding layer of slice physical model.

Step S11: the control module 20 moves the curing platform 24 by the lifting module 27 for making a vertical distance between a modeling plane of the curing platform 24 and the bottom of the material tank 23 (such as the center of the demodeling film 40) be a default thickness h2 (as shown in Fig. 5A). One of the exemplary embodiments, the default thickness h2 is not greater than 0.1 millimeters, such as 0.1 millimeters or 0.05 millimeters.

One of the exemplary embodiments, the demodeling film 40 is made from light-transmissive silicon film or Teflon film.

One of the exemplary embodiments, the modeling plane may be a worktop of the curing platform 24 or a printed top layer of slice physical model. For example, the modeling plane may be the worktop of the curing platform 24 when printing the first layer of slice physical model, and be the previous layer of slice physical model when printing the second or higher layer of slice physical model.

Step S12: the control module 20 controls the light module 21 to irradiate heading to the modeling plane according to the selected layer of print data for printing one layer of slice physical model.

One of the exemplary embodiments, each layer of the print data is a 2D image, the control module 20 may control the light module 21 to irradiate heading to a plurality of positions respectively corresponding to a plurality of pixels of one layer of print data according to a plurality of pixel values of the pixels of the selected layer of print data for printing one layer of slice physical model (as the first layer of slice physical model 42 shown in Fig. 5B).

Step S13: the control module 20 retrieves a printing area value of the currently selected layer of slice physical model printed in the step S12.

One of the exemplary embodiments, the control module 20 may calculate the printing area value of the currently selected slice physical model according to the selected layer of print data (such as the first layer of print data).

Step S14: the control module 20 determines whether the printing area value of the currently selected layer of slice physical model (such as the first layer of slice physical model 42) is not less than a default threshold (first threshold, such as 300).

One of the exemplary embodiments, above threshold is determined based on a moving speed of the material tank 23 or a lifting speed of the curing platform 24.

Please be noted that the provided horizontal force is smaller if the moving speed of the material tank 23 is faster. The provided lifting force is smaller if the lifting speed of the curing platform 24 is faster. The required force used to peel the current layer of slice physical model from the demodeling film 40 is stronger if the printing area value of the current layer of slice physical model is bigger, and vice versa.

One of the exemplary embodiments, above-mentioned threshold is inversely proportional to the lifting speed of the curing platform 24. For example, the threshold is smaller if the lifting speed of the curing platform 24 is faster. Namely, it is necessary to use the moving operation on the peeling when the printing area value is smaller because the lifting force is insufficient.

Conversely, the threshold is greater if the lifting speed of the curing platform 24 is slower. Namely, it can use the moving operation on the peeling when the printing area value is bigger because the lifting force is sufficient.

One of the exemplary embodiments, above-mentioned threshold may be configured to a smaller value (such as 100), and the moving speed of the material tank 23 may be changed by the printing area value. Thus, the present disclosed example may use the moving operation on the peeling when the printing area value is smaller. For example, if the printing area value is bigger (namely, the adhesion is greater), the moving speed of the material tank 23 is slower for providing the greater horizontal force to peel the slice physical model. Conversely, if the printing area value is smaller (namely, the adhesion is smaller), the moving speed of the material tank 23 is faster for providing the smaller horizontal force to peel the slice physical model.

The control module 20 performs the step S15 if determining that the printing area value of the currently selected layer of slice physical model is greater than the threshold or equal to the threshold. The control module 20 performs the step S16 if determining that the printing area value is less than the threshold.

Step S15: the control module 20 controls the lifting module 27 to lift the curing platform 24 up when the printing area value is not less than the threshold, and controls the moving module 22 to horizontally moving the material tank 23 during lifting the curing platform 24.

As shown in Fig. 5C, the present disclosed example may provide the horizontal force on the contact surfaces between the first layer of slice physical model 42 and the demodeling film 40 by horizontally moving the material tank 23 to make the light-curable materials 41 in the material tank 23 horizontally flow, so as to make the first layer of slice physical model 42 be easier to be peeled from the bottom of the material tank 23 (namely the demodeling film 40). The first layer of slice physical model 42 and the demodeling film 40 are not easy to be damaged by the peeling operation.

Step S16: the control module 20 controls the lifting module 27 to lift the curing platform 24 up when the printing area value is less than the threshold for peeling the first layer of slice physical model 42 from the bottom (namely the demodeling film 40) of the material tank 23. Moreover, the material tank 23 controlled by the control module 20 doesn't move during lifting the curing platform 24.

Please be noted that the adhesion between the first layer of slice physical model 42 and the demodeling film 40 is smaller when the printing area value of the first layer of slice physical model 42 is smaller, so the first layer of slice physical model 42 may be easily peeled from the demodeling film 40 without rotating the material tank 23. Moreover, the structural strength of the first layer of slice physical model 42 is not robust when the printing area value of the first layer of slice physical model 42 is smaller, the horizontal force generated by rotating the material tank 23 may damage the first layer of slice physical model 42. Thus, the present disclosed example can effectively promote the success rate of printing via directly peeling the slice physical model away from the bottom of the material tank 23 without rotating the material tank 23 when the printing area value is less than the threshold.

One of the exemplary embodiments, the step S15 and the step S16 are configured to control the lifting module 27 to lift the curing platform up for a default lifting height (such as 1.5 millimeters), above lifting height is greater than the default thickness h2.

One of the exemplary embodiments, in the step S15, the lifting height may be less than the lifting height in the step S16 because of the step S15 additionally providing the horizontal force.

Then, after the first layer of slice physical model 42 leaves the demodeling film 40 and completion of lifting, the light-curable materials 41 in the material tank 23 may backfill a space occupied by the first layer of slice physical model 42 previously via naturally flowing and making the liquid level revert to be horizontal.

Step S17: the control module 20 determines whether completion of 3D printing. For example, the control module 20 determines whether all of the multiple layers of slice physical models have been printed.

If the control module 20 determines that there is any layer of slice physical model which do not be printed (namely, the 3D printing is incomplete), the control module 20 performs the step S10 again. Otherwise, the control module 20 finishes printing.

For example, the control module 20 may select the second layer of print data (step S10), make the modeling plane (the top surface of the first layer of slice physical model 42) be the default thickness h2 away from the bottom of the material tank 23 (as shown in Fig. 5D, the step S11), control the light module 21 to irradiate heading to the top surface of the first layer of slice physical model 42 according to the second layer of print data for printing the second layer of slice physical model 43 on the first layer of slice physical model 42 (as shown in Fig. 5E, the step S12). Then, the control module 20 retrieves the printing area value of the second layer of slice physical model 43 (step S13), determines whether the printing area value is not less than the threshold (step S14), and directly lifts the curing platform 24 up without rotating the material tank 23 for directly peeling the second layer of slice physical model 43 away from the bottom of the material tank 23 when determining that the printing area value is less than the threshold (as shown in Fig. 5F, the step S16). Thus, the printing of the second layer of slice physical model 43 is completed and so on. And repeatedly perform above steps until all layers of slice physical models are printed completely and stack as the 3D physical model.

The present disclosed example can drastically reduce a probability of the demodeling film or physical model being damaged during peeling via moving the material tank for applying a horizontal force to assist to peel when the printing area value of the physical model is not less than the threshold.

The present disclosed example can prevent the physical model from damaging by the horizontal force generated by moving the material tank 23 during peeling via directly lifting the curing platform 24 up for peeling when the printing area value of the physical model is less than the threshold.

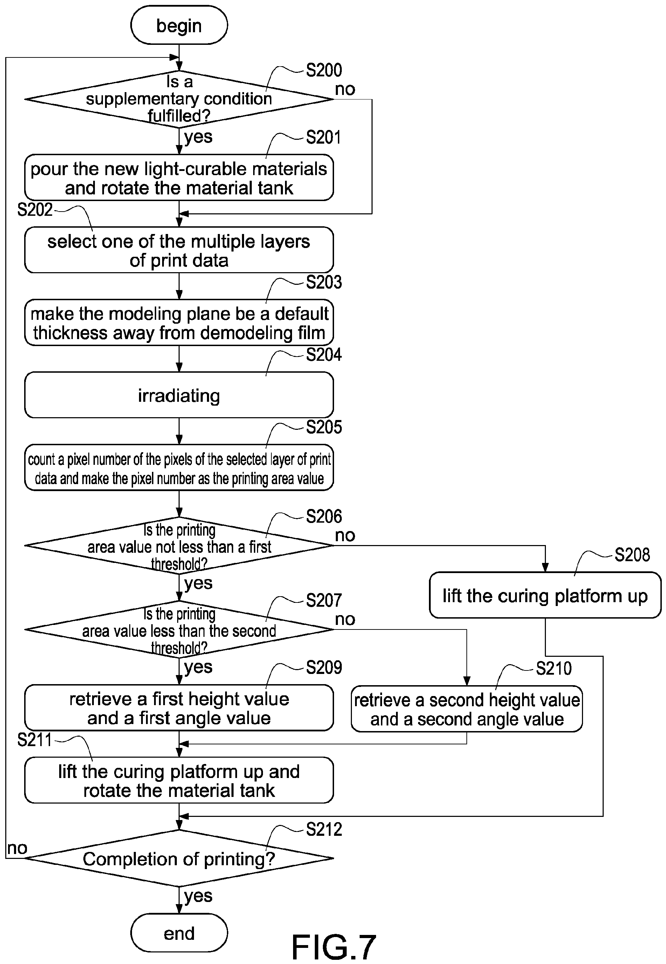

Please refer to Fig. 7 simultaneously, Fig. 7 is a flowchart of a method of peeling physical model from material tank according to a second embodiment of the present disclosed example. Compare to the method of peeling physical model from material tank shown in Fig. 6, the method of peeling physical model from material tank of this embodiment is configured to compare the printing area value with a plurality of thresholds, and adjust the lifting height or the rotating angle according to a comparison result. The method of peeling physical model from material tank of this embodiment comprises following steps.

Step S200: the control module 20 of the stereolithography 3D printer 2 determines whether a default supplementary condition satisfies. More specifically, above-mentioned supplementary condition is configured by a user or a developer in advance and stored in the memory module 29.

One of the exemplary embodiments, the supplementary condition my be any combination of following conditions: the time before printing the first layer of slice physical model 42; each time the designated layers (such as 10 layers) of slice physical models 42 being printed; each time the designated volume of slice physical models 42 being printed; the liquid level of the light-curable materials 41 in the material tank 23 is lower than a default height and so on.

If the supplementary condition satisfies, the control module 20 performs the step S201. Otherwise, the control module 20 performs the step S202.

Step S201: the control module 20 controls the material-providing module 26 to pour the new light-curable materials 41 into the material tank 23.

One of the exemplary embodiments, the material-providing module 26 pours the stored light-curable materials 41 into the material tank 23 by a transportation pipe (as shown in Fig. 4).

One of the exemplary embodiments, during the material-providing module 26 pouring the light-curable materials 41, the control module 20 may control the moving module 22 to move (such as rotating or horizontally moving back and forth) the material tank 23 with a default speed (the second speed, such as 720 degrees per minute) for mixing the existed light-curable materials 41 in the material tank 23 and the poured new light-curable materials 41 evenly and making the mixed light-curable materials 41 fill the material tank 23 evenly.

Step S202: the control module 20 of the stereolithography 3D printer 2 selects one of the multiple layers of print data sequentially, such as the first layer of print data.
step S203: the control module 20 moves the curing platform 24 by the lifting module 27 to make the modeling plane be the default thickness h2 away from the bottom of the material tank 23.

Step S204: the control module 20 controls the light module 21 to irradiate heading to the modeling plane according to the selected layer of print data for printing one layer of slice physical model on the modeling plane.

Step S205: the control module 20 computes the printing area value of the currently selected layer of slice physical model according to the selected layer of print data.

One of the exemplary embodiments, each layer of print data is a 2D image, the control module 20 may count a pixel number of the pixels in a printing region (the printing region may correspond to the region needing to irradiate by light) of the currently selected layer of print data and make the pixel number as the printing area value.

Step S206: the control module 20 determines whether the printing area value of the currently selected layer of slice physical model is not less than a default first threshold (such as 300).

The control module 20 performs the step S207 if determining that the printing area value of the currently selected layer of slice physical model is greater than the first threshold or equal to the first threshold. The control module 20 performs the step S208 if determining that the printing area value is less than the first threshold.

Step S207: the control module 20 determines whether the printing area value of the currently selected layer of slice physical model is less than a default second threshold (such as 600). Above-mentioned second threshold is greater than above-mentioned first threshold.

The control module 20 performs the step S210 if determining that the printing area value of the currently selected layer of slice physical model is greater than the second threshold or equal to the second threshold. The control module 20 performs the step S209 if determining that the printing area value is less than the second threshold.

Step S208: the control module 20 retrieves a default height (this default height is greater than the default thickness h2) as the lifting height when the printing area value of the currently selected layer of slice physical model is less than the first threshold (similarly being less than the second threshold), and controls the lifting module 27 to lift the curing platform 24 for the lifting height for directly peeling the current layer of slice physical model away from the bottom of the material tank 23. Moreover, the material tank 23 controlled by the control module 20 doesn't move during lifting the curing platform 24.

Step S209: the control module 20 retrieves a first height value (such as 1.5 millimeters) corresponding to this threshold interval when the printing area value of the current layer of slice physical model is not less than the first threshold and less than the second threshold (namely the printing area value is between the first threshold and the second threshold), and makes the first height value as the lifting height.

One of the exemplary embodiments, if the moving module 22 is configured to rotate the material tank 23, the control module 20 may further retrieve a first angle value (such as 180 degrees) corresponding to this threshold interval, and make the first angle value as rotating angle.

One of the exemplary embodiments, a lookup table is saved in the memory module 29, the lookup table records a correspondence relationship between a plurality of thresholds (comprising the first threshold and the second threshold), a plurality of height values (comprising the first height value and the second height value) and a plurality of angle values (comprising the first angle value and the second angle value). The control module 20 is configured to searching in the lookup table according to the printing area value for obtaining the first height value and/or the first angle value, make the first height value as the lifting height, and make the first angle value as the rotating angle.

Step S210: the control module 20 retrieves a second height value (such as 2.5 millimeters) corresponding to this threshold interval when the printing area value of the current layer of slice physical model is not less than the first threshold and not less than the second threshold (namely the printing area value is greater than the second threshold or equal to the second threshold), and makes the second height value as the lifting height.

One of the exemplary embodiments, if the moving module 22 is configured to rotate the material tank 23, the control module 20 may further retrieve a second angle value (such as 360 degrees) corresponding to this threshold interval, and make the second angle value as the rotating angle.

One of the exemplary embodiments, the control module 20 is configured to searching in the lookup table according to the printing area value for obtaining the second height value and/or the second angle value, make the second height value as the lifting height, and make the second angle value as the rotating angle.

One of the exemplary embodiments, the second height value is greater than the first height value, and/or the second angle value is greater than the first angle value. More specifically, the adhesion between the slice physical model and the demodeling film 40 increases as the printing area value of the slice physical model increases, thereby, the present disclosed example may further dynamically adjust the lifting height and/or rotating angle according to the printing area value when the printing area value is greater than the first threshold, instead of configuring the fixed lifting height and rotating angle. Thus, the present disclosed example can provide the more appropriate horizontal force having the different strengths based on the different printing area values for peeling the slice physical model successfully.

Step S211: the control module 20 lifts the curing platform 24 up for the configured lifting height (such as the first height value or the second height value), and controls the moving module 22 to move the material tank 23 during lifting the curing platform 24 for peeling the current layer of the slice physical model from the material tank 23.

One of the exemplary embodiments, the control module 20 is configured to control the moving module 22 to move the material tank 23 with a default speed (first speed, such as 360 degrees per minute). Above-mentioned first speed is less than the second speed recited in the step S201. More specifically, during rotation of the step S201, the printed slice physical model completely leaves away from the light-curable materials 41 in the material tank 23, the robust horizontal force generated by a high-speed rotation doesn't damage the printed slice physical model. During rotation of the step S201, the printed slice physical model still soaks in the light-curable materials 41 in the material tank 23, it is very possible that the robust horizontal force generated by the high-speed rotation damages the printed slice physical model.

Step S12: the control module 20 determines whether completion of 3D printing. For example, the control module 20 determines whether all of the multiple layers of slice physical models have been printed.

If the control module 20 determines that there is any layer of slice physical model which do not be printed (namely, the 3D printing is incomplete), the control module 20 performs the step S200 again for printing the next layer of slice physical model. Otherwise, the control module 20 finishes printing.

Please be noted that although in the example of Fig. 7, there are only three threshold intervals (being less than the first threshold, being not less than the first threshold and less than the second threshold, and being not less than the second threshold) respectively corresponding to the different lifting height or rotating angle, but this specific example is not intended to limit the scope of the present disclosed example. The user can modify the number of the threshold intervals arbitrarily according to the user's requirement.

Please be noted that although above-mentioned embodiment is configured to determine the lifting height and the rotating angle according to the printing area value, but this specific example is not intended to limit the scope of the present disclosed example. In another embodiment, the present disclosed example may determine the lifting height and the rotating angle according to a printing volume value (the printing volume value may be a result of the printing area value being multiplied by default thickness).

Take three threshold intervals for example. The stereolithography 3D printer 2 may directly lift the curing platform 24 up for the default height (such as 1.5 millimeters) when the printing volume value is less than 100π cubic millimeter. The stereolithography 3D printer 2 may lift the curing platform 24 up for the first height value (such as being less than 1.5 millimeters) and rotate the material tank 23 for the first angle value (such as being less than 180 degrees) when the printing volume value is between 100π-200π cubic millimeter. The stereolithography 3D printer 2 may lift the curing platform 24 up for the second height value (such as being less than 2.5 millimeters) and rotate the material tank 23 for the second angle value (such as being less than 270 degrees) when the printing volume value is between 200π-300π cubic millimeter. The stereolithography 3D printer 2 may lift the curing platform 24 up for the third height value (such as being less than 3 millimeters) and rotate the material tank 23 for the third angle value (such as being less than 360 degrees) when the printing volume value is greater than 300π cubic millimeter.

Thus, thus, the present disclosed example can provide the more appropriate horizontal force having the different strengths for substantial promoting the probability of peeling the slice physical model successfully. Moreover, the present disclosed example can reduce the necessary lifting height of the curing platform 24 via providing the horizontal force, so as to improve the printing speed.

## Claims

1. A method of peeling physical model from material tank applied to a stereolithography 3D printer (2), the stereolithography 3D printer (2) comprising a light module (21), a curing platform (24), a material tank (23) and a moving module (22), a light-transmissive demodeling film (40) being laid on a bottom of the material tank (23), the method of peeling physical model from material tank comprising following steps:
a) selecting one of multiple layers of print data in order;
b) making a modeling plane of the curing platform (24) be a default thickness (h2) from the demodeling film (40);
c) controlling the light module (21) to irradiate heading to the modeling plane according to the selected layer of print data for printing one layer of slice physical model (42, 43) on the modeling plane;
d) retrieve a printing area value of the printed layer of slice physical model (42, 43);
e) lifting the curing platform (24) up when the printing area value is not less than a first threshold, and controlling the moving module (22) to move the material tank (23) during lifting the curing platform (24) for peeling the layer of slice physical model (42, 43) from the material tank (23); and
f) performing the step a) to the step e) repeatedly until all of the multiple layers of slice physical models have been printed and stack as a 3D physical model.

2. The method of peeling physical model from material tank according to claim 1, further comprising a step g) performed after the step d) before the step f) lifting the curing platform (24) up when determining that the printing area value is less than the first threshold for peeling the layer of slice physical model (42, 43) from the material tank (23), wherein the material tank (23) is not moved during lifting the curing platform (24); the step f) is configured to performing the step a) to the step e) and the step g) repeatedly.

3. The method of peeling physical model from material tank according to claim 1, wherein each layer of print data is a 2D image; the step d) comprises a step d1) counting a pixel number of a plurality of pixels in a printing region of the layer of print data and making the pixel number as the printing area value.

4. The method of peeling physical model from material tank according to claim 1, wherein the step e) comprises following steps:
e1) retrieving a first height value as a lifting height when the printing area value is not less than the first threshold; and
e2) lifting the curing platform (24) up for the lifting height, and controlling the moving module (22) to move the material tank (23) during lifting the curing platform (24) for peeling the layer of slice physical model (42, 43) from the material tank (23).

5. The method of peeling physical model from material tank according to claim 4, wherein the step e) further comprises a step e3) performed before the step e1) retrieving a second height value as the lifting height when the printing area value is not less than a second threshold; wherein the second threshold is greater than the first threshold, the second height value is greater than the first height value; wherein the step e1) is configured to retrieve the first height value as the lifting height when the printing area value is not less than the first threshold and less than the second threshold.

6. The method of peeling physical model from material tank according to claim 5, wherein the step e1) is configured to searching in a lookup table according to the printing area value for obtaining the first height value and a first angle value, and making the first angle value as a rotating angle; wherein the step e3) is configured to searching in the lookup table according to the printing area value for obtaining the second height value and a second angle value, and making the second angle value as a rotating angle; wherein the lookup table records a correspondence relationship between a plurality of thresholds, a plurality of height values and a plurality of angle values, the thresholds comprises the first threshold and the second threshold, the height values comprises the first height value and the second height value, the angle values comprises the first angle value and the second angle value; the step e2) is configured to lift the curing platform (24) up for the lifting height and control the moving module (22) to rotate the material tank (23) for the rotating angle during lifting the curing platform (24).

7. The method of peeling physical model from material tank according to claim 1, wherein the demodeling film (40) is made from light-transmissive silicone or Teflon, the modeling plane is a worktop of the curing platform (24) or the printed top layer of slice physical model (42, 43).

8. The method of peeling physical model from material tank according to claim 1, further comprising following steps before the step a):
h1) controlling a material-providing module (26) of the stereolithography 3D printer (2) to pour the new light-curable materials (41) into the material tank (23) when a supplementary condition is fulfilled; and
h2) controlling the moving module (22) to move the material tank (23) during pouring the new light-curable materials (41) for making the light-curable materials (41) flow.

9. The method of peeling physical model from material tank according to claim 8, wherein the step e) is configured to move the material tank (23) with a first speed; the step h2) is configured to move the material tank (23) with a second speed; the first speed is slower than the second speed.

10. The method of peeling physical model from material tank according to claim 1, wherein each layer of print data is a 2D image; the step c) is configured to control the light module (21) to irradiate heading a plurality of positions of the modeling plane corresponding to a plurality of pixels of the layer of print data according to a plurality of pixel values of the pixels for printing one layer of slice physical model (42, 43).

11. The method of peeling physical model from material tank according to claim 1, wherein the first threshold is determined by a moving speed of the material tank (23) or a lifting speed of the curing platform (24).
